(19) **Europäisches Patentamt**

**European Patent Office**

**Office européen des brevets**

(11) **EP 1 230 557 B1**

(12) **EUROPÄISCHE PATENTSCHRIFT**

(45) Veröffentlichungstag und Bekanntmachung des Hinweises auf die Patenterteilung:
**07.04.2004 Patentblatt 2004/15**

(21) Anmeldenummer: **00956464.2**

(22) Anmeldetag: **18.08.2000**

(51) Int Cl.$^7$: **G01R 33/07**, H01L 43/04

(86) Internationale Anmeldenummer:
**PCT/EP2000/008091**

(87) Internationale Veröffentlichungsnummer:
**WO 2001/035113 (17.05.2001 Gazette 2001/20)**

(54) **Offset-reduziertes Hall-Element**

Offset-reduced Hall element

Elément à effet Hall à décalage réduit

(84) Benannte Vertragsstaaten:
**AT BE CH CY DE DK ES FI FR GB GR IE IT LI LU MC NL PT SE**

(30) Priorität: **11.11.1999 DE 19954360**

(43) Veröffentlichungstag der Anmeldung:
**14.08.2002 Patentblatt 2002/33**

(73) Patentinhaber: **Fraunhofer-Gesellschaft zur Förderung der angewandten Forschung e.V. 80686 München (DE)**

(72) Erfinder:
• **HOHE, Hans-Peter**
**D-91332 Heiligenstadt (DE)**

• **SAUERER, Josef**
**D-91074 Herzogenaurach (DE)**

(74) Vertreter: **Schoppe, Fritz, Dipl.-Ing.**
**Patentanwälte Schoppe, Zimmermann, Stöckeler & Zinkler,**
**Postfach 246**
**82043 Pullach bei München (DE)**

(56) Entgegenhaltungen:
**DE-A- 1 490 587      DE-B- 1 019 745**
**GB-A- 860 200        US-A- 3 293 586**

• **PATENT ABSTRACTS OF JAPAN vol. 015, no. 296 (P-1231), 26. Juli 1991 (1991-07-26) & JP 03 102277 A (HINODE PAWATORONIKUSU KK), 26. April 1991 (1991-04-26)**

**Beschreibung**

Die vorliegende Erfindung bezieht sich auf Hall-Elemente, und insbesondere auf Hall-Elemente mit Offset-Kompensation.

Hall-Elemente nutzen den Hall-Effekt beispielsweise zur Messung eines Magnetfelds aus. Unter dem Hall-Effekt versteht man das Auftreten eines auf den Stromdichtevektor j senkrecht stehenden elektrischen Feldes als Folge der Einwirkung eines Magnetfelds B. Das senkrecht stehende elektrische Feld E berechnet sich nach folgender Gleichung:

$$E = -R \, (j \times B).$$

In dieser Gleichung wird R als Hall-Konstante bezeichnet. Für Störstellenhalbleiter ist die Hall-Konstante proportional zur Differenz zwischen der Beweglichkeit der Löcher im Halbleiter und der Beweglichkeit der Elektronen im Halbleiter.

Materialien, die Hall-Konstanten haben, die ausreichend groß sind, um als Substrat bzw. Sensor-Bereich oder einfach Bereich für ein Hall-Element verwendet zu werden, sind beispielsweise eigenleitfähiges InSb, In(AsP), InAs oder leicht p- oder n-dotierte Bereiche auf Silizium. Zwei Kontakte werden dazu verwendet, um einen Betriebsstrom durch den Bereich zu leiten.

Die anderen beiden Kontakte dagegen werden dazu verwendet, um die Hall-Spannung abzugreifen, die sich aufgrund der Lorentz-Kraft aufbaut, die aufgrund eines auf das Hall-Element wirkenden Magnetfelds zu einer Ablenkung der sich bewegenden Ladungsträger führt. Nach kurzer Zeit entsteht im Hall-Element ein elektrisches Feld, das senkrecht zum Betriebsstrom gerichtet ist, und das so groß ist, daß die auf die Ladungsträger des Betriebsstroms wirkende Lorentz-Kraft kompensiert ist.

Der Hall-Effekt bzw. ein Hall-Element kann neben der Messung eines Magnetfelds nach Betrag und Vorzeichen auch zur Multiplikation zweier elektrischer Größen, d. h. dem Magnetfeld und dem Steuerstrom, oder auch für kontaktfreie Signalgeber eingesetzt werden. Eine weitere Möglichkeit besteht darin, ein Hall-Element in der Nähe einer Leiterbahn anzuordnen und den Strom in dieser Leiterbahn über die Erfassung des durch den Strom durch die Leiterbahn erzeugten Magnetfelds kontaktlos zu messen.

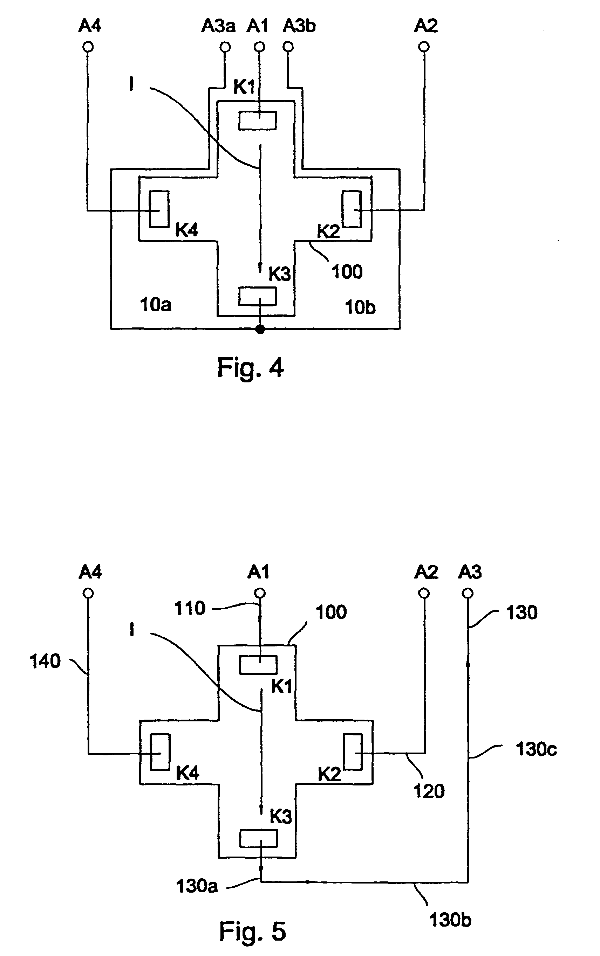

In Fig. 5 ist ein planares Hall-Element 100 skizziert. Es umfaßt einen Bereich 100, der aus einem Material gebildet ist, das eine ausreichend große Hall-Konstante besitzt. Es sei darauf hingewiesen, daß im Sinne dieser Beschreibung der Bereich des Hall-Elements, der eine Hall-Konstante ungleich Null hat, entweder ein eigenes Hall-Substrat sein kann, was für größere Hall-Elemente zutreffen könnte, daß der Bereich jedoch auch ein Bereich oder Gebiet einer integrierten Schaltung sein kann, der in bekannter Weise in dem IC-Substrat z. B. in einer Wanne eingebettet oder durch bestimmte Technologieschritte modifiziert worden ist, um eine entsprechende Hall-Konstante zu haben.

Der Bereich, der in Fig. 5 gezeigt ist, ist kreuzförmig ausgestaltet, was den Vorteil mit sich bringt, daß das in Fig. 5 gezeigte Hall-Element auch für den sogenannten Spinning-Current-Betrieb geeignet ist, d. h. daß der Betriebsstrom I über Kontakte K1 und K3 durch den Bereich 100 geleitet werden kann, daß jedoch in einem anderen Betriebsmodus auch der Betriebsstrom I über die Kontakte K2 und K4 durch den Bereich geleitet werden kann, während dann die Hall-Spannung selbstverständlich an den Kontakten K1 und K3 vorhanden ist, derart, daß dieselbe an den Anschlüssen A1 und A3 abgegriffen werden kann. Für die nachfolgenden Betrachtungen wird jedoch ohne Beschränkung der Allgemeinheit aus Übersichtlichkeitsgründen davon ausgegangen, daß der Betriebsstrom I über die Anschlüsse A1 und A3 angelegt wird, d. h. über die Kontakte K1 und K3 in den Bereich eingespeist bzw. herausgeführt wird, während die Hall-Spannung durch eine Potentialdifferenz zwischen den Kontakten K2 und K4 gegeben ist, d. h. an den Anschlüssen A2 und A4 abgegriffen werden kann.

Neben dem Bereich 100 mit einer Hall-Konstante ungleich Null und den Kontakten K1, K2, K3 und K4 zum Kontaktieren des Bereichs 100 benötigt ein Hall-Element selbstverständlich auch Zuleitungen 110, 120, 130 und 140, um die entsprechenden Kontakte K1 bis K4 mit den entsprechenden Anschlüssen A1 bis A4 elektrisch zu verbinden. Bei dem in Fig. 5 gezeigten bekannten Hall-Element werden die Zuleitungen 110 bis 140 nach den praktischen Gegebenheiten gestaltet. Praktische Gegebenheiten bestehen insbesondere darin, daß beispielsweise die Forderung besteht, daß sämtliche Anschlüsse A1 bis A4 nahe beieinander liegen sollen, um beispielsweise an eine zentrale Umschalteinheit für den Spinning-Current-Betrieb herangeführt zu werden. In diesem Fall ist es wie in Fig. 5 gezeigt erforderlich, zumindest eine Zuleitung, nämlich die Zuleitung 130, um den Hall-Bereich 100 herum zu führen. Anders ausgedrückt, umfaßt die Zuleitung 130 einen der Richtung des Stroms I entsprechenden ersten Abschnitt 130a, einen dazu senkrechten zweiten Abschnitt 130b sowie einen zum Strom I parallel gerichteten Abschnitt 130c, in dem jedoch der Strom in der dem Betriebsstrom I entgegengesetzten Richtung fließt.

Wie es bereits ausgeführt worden ist, dienen Hall-Elemente dazu, ein äußeres Magnetfeld, das auf den Hall-Bereich wirkt, zu messen. Um eine solche Magnetfeldmessung durchzuführen, muß jedoch ein Betriebsstrom durch den Bereich geschickt werden, so daß eine Lorentz-Kraft auf bewegte Ladungsträger überhaupt erst wirken kann. Selbstverständlich hat auch dieser Betriebsstrom I wie jeder Strom ein Magnetfeld, das ebenfalls zu lokalen Hall-Spannungen im Bereich führt. Da die Auswirkungen dieses lokalen Eigenfelds jedoch symmetrisch bezüglich der Mittelachse des Stroms im Element selbst sind, entsteht am Element außen, d. h. an den Kontakten K2 und K4, keine Hall-Spannung, die über die Anschlüsse A2 und A4 abgegriffen werden könnte. Dieses lokale Eigenfeld des Betriebsstroms I im Hall-Bereich wirkt jedoch in seiner vollen Größe auf Nachbar-Hall-Elemente, wenn Arrays aus Hall-Elementen verwendet werden, wie es beim Spinning-Current-Betrieb mit mechanischer Vorkompensation auftritt. Das Eigen-Magnetfeld eines Hall-Elements in einem Array von Hall-Elementen führt somit aufgrund seines erzeugten Magnetfelds, das das Nachbar-Element durchdringt, dort zu einem Meßsignal, welches sich wie ein Offset bemerkbar macht. Das durch den Betriebsstrom erzeugte Magnetfeld überlagert sich also dem eigentlich zu messenden äußeren Magnetfeld. Durch das magnetische Eigenfeld des aktiven Sensorbereichs ergibt sich somit immer ein Offset-Problem, wenn sich mehrere Sensoren in unmittelbarer Nähe befinden, da die Eigenfelder der Sensoren auf die jeweils anderen Sensoren wie ein äußeres Magnetfeld wirken.

Ein weiteres Problem ergibt sich bei der in Fig. 5 gezeigten bekannten Anordnung aus den Anschlußzuführungen 110 bis 140, die jedes Hall-Element besitzen muß. Um die Anschlüsse A1 bis A4 des Hall-Elements einer Ansteuerschaltung zuzuführen, muß, wie es bereits ausgeführt worden ist, in der Regel mindestens einer der stromführenden Anschlüsse, im Beispiel von Fig. 5 der Anschluß 130, um den Bereich 100 herum geführt werden. Bei dem in Fig. 5 gezeigten typischen Beispiel für den Stand der Technik besteht die ungünstige Zuleitung vom Anschluß A3 bis zum Kontakt K3 aus den, wie es in Fig. 5 gezeigt ist, unterschiedlich ausgerichteten Teilstücken 130a bis 130c.

Die Zuleitungen 130a - 130c liefern folgende Magnetfelder. Das Magnetfeld, das der Betriebsstrom erzeugt, der durch das Element 130a fließt, ist noch zum Stromfluß im aktiven Teil des Hall-Bereichs symmetrisch und erzeugt deshalb in dem Bereich 100 keine außen meßbare Hall-Spannung. Dies trifft jedoch nicht mehr für die beiden Teilstücke 130b und 130c zu. Das in diesen Leitern erzeugte Magnetfeld wirkt in seiner vollen Größe auf den Bereich und wird von diesem mitgemessen, d. h. führt selbst zu einer Hall-Spannung zwischen den Anschlüssen A2 und A4. Da dieses Zusatzfeld immer vorhanden ist, wenn das Element in Betrieb ist, wirkt es nach außen wie ein fester Offset, den das Element besitzt. Lediglich durch Verändern des Betriebsstroms kann dieser Anteil von einem wirklichen Offset dadurch unterschieden werden, daß sich ein normaler Offset linear mit dem Betriebsstrom verändert, während sich der durch Störfelder vom Betriebsstrom verursachte Offset quadratisch mit dem Betriebsstrom verändert.

Die DE 1019 745 A offenbart eine magnetfeldabhängige Widerstandsanordnung und insbesondere einen Hallgenerator, bei dem ein Widerstandskörper eine quaderförmige Form aufweist, der an zwei gegenüberliegenden schmalen Seiten Kontakte zum Zuführen eines Betriebsstroms bzw. zum Abführen eines Betriebsstroms umfaßt. An jede Elektrode ist ein seitlich um den Widerstandskörper herum führender Zuleitungsdraht angeschlossen. In der Mitte zweier anderer Seiten des Quaders sind die Abnahmestellen der Hall-Spannung angeordnet, mit denen Zuleitungsdrähte verbunden sind. Die Zuleitungsdrähte sind ineinander verdrillt.

Das U.S.-Patent Nr. 3,293,586 offenbart ein Hallplattenelement mit einem halbleitenden Material, das den Hall-Effekt aufweist, und das auf einer Schicht aus mechanisch schützendem isolierenden Material aufgebracht ist. Kontakte zum Zuführen eines Betriebsstroms werden durch Aufbringen eines leitfähigen Materials in elektrischem Kontakt mit dem halbleitenden Material gebildet. Ferner werden Kontakte zum Abgreifen der Hallspannung an dem halbleitenden Material durch Erzeugen eines Ohmschen Kontakts mit dem halbleitenden Material hergestellt. Mit den Ohmschen Kontakten sind leitfähige Streifen verbunden, die sich über das halbleitende Material hinaus erstrecken, damit an dieselben Kontaktdrähte gelötet werden können.

Die Aufgabe der vorliegenden Erfindung besteht darin, ein Hall-Element zu schaffen, das einen reduzierten Offset hat.

Diese Aufgabe wird durch ein Hall-Element gemäß Patentanspruch 1 oder 6 gelöst.

Der vorliegenden Erfindung liegt die Erkenntnis zugrunde, daß von der bisherigen Ansicht, die Zuleitungen lediglich nach den praktischen Gegebenheiten jedoch ohne Rücksicht auf den Betrieb des Hall-Elements bzw. auf seine Auswirkungen auf die Umwelt auszuführen, abgegangen werden muß, um ein offset-reduziertes Hall-Element zu schaffen, das zum einen einen reduzierten Offset aufgrund seines eigenen Betriebsstroms hat, und das zum anderen auch eine geringere Auswirkung auf benachbarte Hall-Elemente hat. Obwohl in der Technik Verfahren existieren dürften, um solche Offset-Fehler heraus zu kalibrieren, ist es generell immer besser, solche Fehler erst gar nicht entstehen zu lassen, wodurch zuverlässigere und weniger aufwendige und damit preisgünstigere Elemente implementiert werden können.

Im Gegensatz zum Stand der Technik, bei dem die Betriebsstromzuleitungen einfach nach den äußeren praktischen Gegebenheiten gestaltet wurden, umfaßt ein erfindungsgemäßes Hall-Element eine Leiterstruktur, die mit dem ersten oder dem dritten Kontakt verbunden ist und den Bereich seitlich im wesentlichen umgibt oder oberhalb oder unterhalb des Bereichs angeordnet ist. Eine solche Leiterstruktur führt dazu, daß sich die Magnetfelder des Stroms durch das Hall-Element und eines Stroms in der Leiterstruktur zur Rückführung des Betriebsstroms in einem Bereich außerhalb des Hall-Elements, d. h. dort, wo andere Hall-Elemente plaziert sein können, zumindest teilweise gegenseitig aufheben, während gleichzeitig das Magnetfeld des Stroms in den Zuleitungen ebenfalls möglichst symmetrisch auf den Bereich wirkt, so daß das durch den Strom in der Leiterstruktur erzeugte Magnetfeld selbst nicht zu einer Hall-Spannung in dem Element führt. Damit wird erfindungsgemäß das Eigen-Magnetfeld eines Hall-Elements vor anderen Hall-Elementen durch einfache Maßnahmen zumindest teilweise abgeschirmt, und es wird zusätzlich erreicht, daß das Magnetfeld der Zuführungen zumindest einigermaßen symmetrisch auf das Hall-Element selbst wirkt, so daß der Betriebsstrom zu keiner Hall-Spannung an dem Element selbst führt.

Bei einem ersten Ausführungsbeispiel der vorliegenden Erfindung ist die Leiterstruktur als flächige Metallisierung über dem Bereich ausgeführt, so daß in Analogie zu zwei benachbart angeordneten flachen Leitern mit unterschiedlicher Stromflußrichtung im Inneren, d. h. zwischen dem Bereich und der Metallisierungsebene, ein theoretisch doppelt so großes Magnetfeld tangential zur Oberfläche des Bereichs vorhanden ist, während die senkrecht zur Oberfläche verlaufenden Felder und alle außerhalb der Anordnung aus Bereich und Metallisierungsfläche befindlichen im wesentlichen Null bzw. stark reduziert sind.

Da der Hall-Bereich nur Felder, die senkrecht zur Oberfläche verlaufen, detektieren kann, führt dies zu einer deutlichen Reduzierung des durch das Eigenfeld hervorgerufenen elektrischen Feldes im Element.

Diese Metallisierungsfläche kann entweder oberhalb oder unterhalb des Bereichs angeordnet sein und eine geometrische Form haben, die der des Bereichs entspricht, was zu einem deutlich verringerten Offset führt, oder eine Form, die nicht der geometrischen Form des Bereichs entspricht, was zwar zu einem etwas höheren Offset führt, jedoch bereits zu deutlichen Verbesserungen gegenüber dem Stand der Technik.

Gemäß einem weiteren Ausführungsbeispiel der vorliegenden Erfindung umfaßt die Leiterstruktur zur Rückführung einen ersten Abschnitt und einen zweiten Abschnitt, die sich in der Nähe des dritten Kontakts verzweigen und vorzugsweise symmetrisch um den Bereich herum geführt werden, um den Bereich im wesentlichen zu umgeben. Auch hier findet eine Verschiebung des Magnetfelds in der Umgebung des Hall-Bereichs statt, so daß das Magnetfeld in der Umgebung des Hall-Bereichs symmetrisch zu diesem wird und damit nicht zu einer Hall-Spannung führt. Außerhalb der Rückführung, d. h. in Gebieten, in denen andere Hall-Elemente plaziert sein können, ist dagegen lediglich ein stark reduziertes Magnetfeld vorhanden. Dieses Ausführungsbeispiel ist schaltungstechnisch einfacher zu realisieren, da keine unterschiedlichen Metallisierungsebenen benötigt werden. Es hat jedoch im Vergleich zu einer zweiten Metallisierungsebene als Leiterstruktur den Nachteil, daß der Offset etwas höher ist.

Zusammenfassend kann somit festgestellt werden, daß die erfindungsgemäße Leiterstruktur, dadurch, daß sie den Bereich seitlich im wesentlichen umgibt oder ober- oder unterhalb des Bereichs angeordnet ist, gleichzeitig sowohl den störenden Einfluß der Rückleitung auf den Bereich als auch das Eigenfeld, das auf andere Hall-Elemente wirkt, die in der Nähe angeordnet sind, reduziert.

Bevorzugte Ausführungsbeispiele der vorliegenden Erfindung werden nachfolgend bezugnehmend auf die Zeichnungen detailliert erläutert. Es zeigen:

Fig. 1A    ein Hall-Element gemäß einem ersten Ausführungsbeispiel der vorliegenden Erfindung;

Fig. 1B    ein Hall-Element gemäß einem weiteren Ausführungsbeispiel der vorliegenden Erfindung;

Fig. 2     ein Querschnitt eines in Fig. 1A oder Fig. 1B gezeigten Hall-Elements;

Fig. 3     ein Hall-Element gemäß einem weiteren Ausführungsbeispiel der vorliegenden Erfindung;

Fig. 4     ein Hall-Element gemäß einem weiteren Ausführungsbeispiel der vorliegenden Erfindung; und

Fig. 5     ein bekanntes Hall-Element.

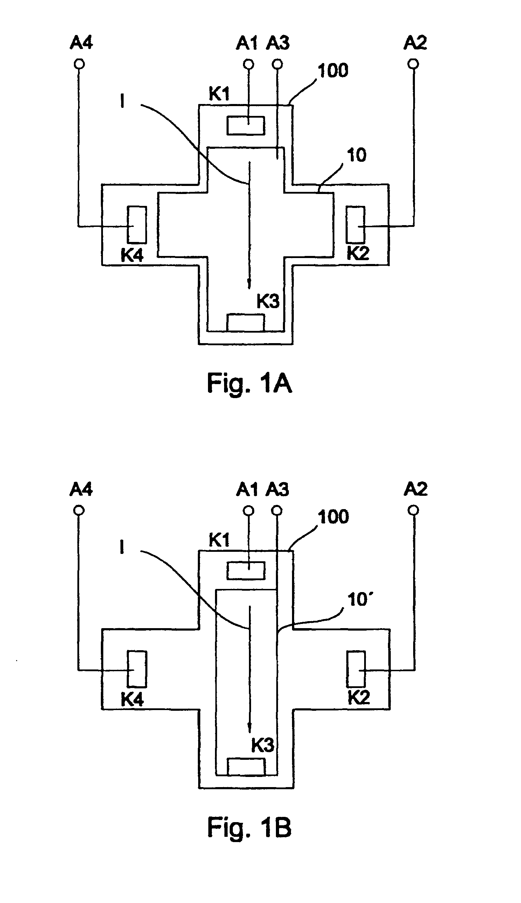

Fig. 1A zeigt ein Hall-Element gemäß einem ersten bevorzugten Ausführungsbeispiel der vorliegenden Erfindung. Das Hall-Element umfaßt ebenso wie das in Fig. 5 gezeigte Hall-Element einen Bereich 100, der eine Hall-Konstante ungleich Null hat, vier Kontakte K1, K2, K3 und K4 sowie vier Anschlüsse A1 bis A4, die jeweils mit ihren entsprechenden Kontakten verbunden sind, wie es in Fig. 1A gezeigt ist. Im Gegensatz zu dem bekannten Hall-Element, das in Fig. 5 gezeigt ist, umfaßt das Hall-Element, das in Fig. 1A gezeigt ist, als Leiterstruktur eine Metallisierung 10, die bei dem in Fig. 1A gezeigten Ausführungsbeispiel oberhalb des Bereichs 100 angeordnet ist. Es sei jedoch darauf hingewiesen, daß die Metallisierung 10 auch unterhalb des Bereichs angeordnet sein könnte, was den gleichen Effekt ergeben würde.

Die Zuleitungen von den Anschlüssen A2 und A4 zu den Kontakten K2 und K4 können bei statischem Betrieb wie üblich gewählt werden, da sie bezüglich Magnetfeldern unproblematisch sind, da in ihnen nahezu keine Ströme fließen, wenn die Hall-Spannung stromlos gemessen wird.

Im Falle einer Betriebsart entsprechend "Spinning-Current" müssen jedoch auch die Kontakte K2 und K4 entsprechend den Kontakten K1 und K3 ausgeführt werden. Dies bedeutet eine weitere Metallisierungsebene über dem Hall-Bereich, die beispielsweise den Kontakt K4 entsprechend dem Kontakt K3 über dem Bereich an die Stelle des Kontaktes K2 zurückführt.

Bei dem in Fig. 1A gezeigten Ausführungsbeispiel der vorliegenden Erfindung ist die geometrische Form der Leiterstruktur 10 im wesentlichen gleich der geometrischen Form des Bereichs 100, bis auf die Tatsache, daß die Kontakte K1, K2 und K4 nicht bedeckt sind, derart, daß hier die Zuleitungen von den Anschlüssen A1, A2 und A4 problemlos angeschlossen werden können. Wenn jedoch eine geeignete Technologie eingesetzt wird, kann sich die Leiterstruktur auch vollständig über den Bereich 100 erstrecken bzw. größer als der Bereich sein, wobei jedoch die besten Kompensationsergebnisse erzielt werden, wenn auch die Leiterstruktur 10 bezüglich der Symmetrieachse des Bereichs symmetrisch ist.

In Fig. 1B ist eine flächenmäßig reduzierte Leiterstruktur gezeigt, die nur noch als Streifen 10' ausgeführt ist und zu einer nicht so vollständigen Offset-Kompensation wie die Leiterstruktur 10 von Fig. 1A führt, die jedoch bereits erhebliche Verbesserungen gegenüber dem Stand der Technik mit sich bringt. Die besten Offset-Reduktionsergebnisse werden wieder dann erzielt, wenn die Leiterstruktur 10' symmetrisch bezüglich der Symmetrieachse des Bereichs 100 angeordnet ist, wobei, falls der Bereich 100 wie im Fall der Fig. 1A und 1B, bei denen der Bereich kreuzförmig ist, zwei Symmetrieachsen hat, die Leiterstruktur zur Symmetrieachse, entlang der der Betriebsstrom I durch den Bereich 100 fließt, symmetrisch sein sollte.

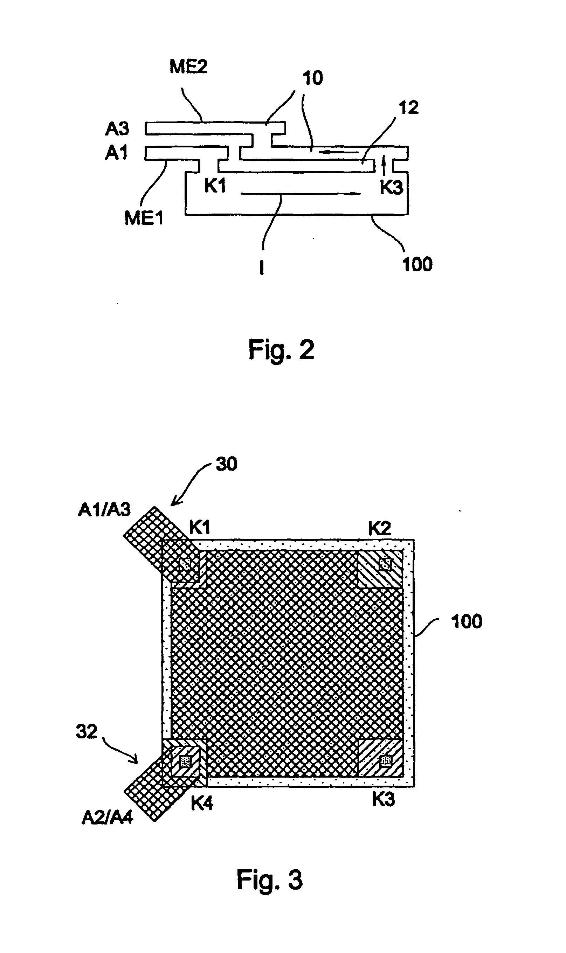

Fig. 2 zeigt einen Längsschnitt durch das in Fig. 1A bzw. Fig. 1B gezeigte Hall-Element. Es sei angenommen, daß der Betriebsstrom über den Anschluß A1 und die Zuleitung vom Anschluß A1 zum Kontakt K1 in den Bereich 100 eingeführt wird und dort entlang des Pfeils, der mit I gekennzeichnet ist, bis zum Kontakt K3 fließt, dort ein kurzes Stück nach oben fließt und dann die Richtung umkehrt und wieder in zum Betriebsstrom I im Bereich 100 entgegengesetzter Richtung zurück zum Anschluß A3 fließt.

Bezüglich der Stromführung außerhalb des Bereichs sei angemerkt, daß es auch hier, um die Auswirkungen auf benachbarte Hall-Elemente zu verringern, sinnvoll ist, daß die Zu- und die Ableitung des Betriebsstroms in zwei verschiedenen Ebenen übereinander weitergeführt werden. Dies ist bei vielen Herstellungstechnologien durch zwei Metallisierungsebenen ME1 und ME2 möglich, wie es in Fig. 2 skizziert ist. Alternativ können die Leitungen auch unmittelbar nebeneinander oder sogar ineinander gekämmt geführt werden, um zu erreichen, daß die Magnetfelder der beiden Leiter außer im Bereich zwischen den Leitern stark reduziert sind. Für den Raum zwischen dem Bereich 100 und der Metallisierungsstruktur 10 kann jedes beliebige Dielektrikum 12 verwendet werden, das typischerweise durch die verwendete Technologie vorgegeben sein wird.

Es sei darauf hingewiesen, daß durch die antiparallele Stromführung im Bereich 100 einerseits und in der Leiterstruktur 10 andererseits der Effekt auftritt, daß im Dielektrikum 12 ein relativ starkes Magnetfeld auftritt, während im Bereich außerhalb der Leiterstruktur, d. h. oberhalb der Leiterstruktur 10 bzw. unterhalb des Bereichs 100 ein stark reduziertes Magnetfeld vorhanden ist, da sich die beiden Magnetfelder dort gegenseitig aufheben. Das im Dielektrikum 12 vorhandene sehr starke Magnetfeld wirkt sich jedoch aufgrund der vorhandenen Richtung (tangential zur Oberfläche) nicht als Hallspannung aus, so daß aufgrund dessen keine Hall-Spannung zwischen den Kontakten K2 und K4 auftritt. Es sei darauf hingewiesen, daß vollständige Symmetrieeigenschaften der Leiterstruktur 10 zwar angestrebt werden, jedoch nicht immer realisiert werden können. Der Kompensationseffekt nimmt jedoch nicht schlagartig ab, sondern langsam, so daß bestimmte Asymmetrien aufgrund äußerer Umstände hingenommen werden können, da immer noch ein bedeutsamer Teil an Magnetfeldaufhebung im Außenbereich auftritt.

Es ist offensichtlich, daß die Leiterstruktur 10 auch unterhalb des Bereichs 100 geführt werden kann, und daß die damit erreichbaren Effekte im wesentlichen die gleichen sind, wie wenn der Rückstrom oberhalb des Bereichs geführt wird, d. h. die Leiterstruktur 10 oberhalb des Bereichs 100 vorhanden ist.

Im nachfolgenden wird auf Fig. 3 eingegangen, die ein erfindungsgemäßes Hall-Element mit zwei Metallisierungsebenen zeigt, wobei die für die Kontakte K1 und K3 in den Fig. 1A, 1B und 2 dargestellte Rückleitung in analoger Weise auch für die Kontakte K2 und K4 auf der anderen Metallisierungsebene realisiert sind. Ein solches Element hat dann nur noch an zwei Seiten Anschlußbereiche 30 und 32, wobei beide Anschlußbereiche entweder als Zu- und Abführung des Betriebsstroms (Anschlußbereich 30 für die Anschlüsse A1 und A3) oder als Hall-Spannungs-Abgriff (Anschlußbereich 32 für die Anschlüsse A2 und A4) verwendet werden können. In Fig. 3 ist der Bereich 100 quadratisch ausgeführt. Es existiert ferner eine erste Metallisierungsebene, die in Fig. 3 als von links oben nach rechts unten schraffiert gezeigt ist, sowie eine zweite Metallisierungsebene, die in Fig. 3 als von links unten nach rechts oben schraffiert gezeigt ist. Die beiden Kontakte K1 und K2 stellen eine Verbindung zwischen dem Hall-Bereich 100 und der ersten Metallisierungsebene, d. h. der von links oben nach rechts unten schraffierten Metallisierungsebene, her, während die Kontakte K3 und K4 einen Kontakt zwischen dem Bereich 100 und der zweiten Metallisierungsebene, d. h. der von links unten nach rechts oben schraffierten Metallisierungsebene, herstellen. Die rautenförmige Schraffur im wesentlichen Teil von Fig. 3 und in den Anschlußbereichen 30 und 32 soll schematisch zum Ausdruck bringen, daß hier beide Metallisierungsebenen, d. h. die erste Metallisierungsebene und die zweite Metallisierungsebene, übereinander vorhanden sind, jedoch selbstverständlich voneinander isoliert.

Der Betriebsstrom wird über die erste Metallisierungsebene dem Kontakt K1 zugeführt und von dort in den Bereich 100 geleitet, wo der Betriebsstrom dann zum Kontakt K3 fließt und von dort über den Kontakt K3 die zweite Metallisierungsebene erreicht, um über die zweite Metallisierungsebene wieder zum Anschlußbereich 30 zurückzufließen, wobei der Anschluß A3 nun durch die obere Metallisierungsebene gebildet wird. Aus Fig. 3 ist ersichtlich, daß die erste Metallisierungsebene um den Kontaktbereich K1 herum von der ersten Metallisierungsebene, die über der sonstigen Fläche des Bereichs 100 angeordnet ist, isoliert ist, und daß auch im Bereich des Kontakts K3 die erste Metallisierungsebene nicht vorhanden ist, um keinen Kurzschluß zwischen der ersten und der zweiten Metallisierungsebene zu bewirken.

Der Anschluß A2 ist über die zweite Metallisierungsebene mit dem Kontakt K4 und über den Kontakt K4 mit dem Bereich 100 verbunden. Das Hall-Element ist ferner über den Kontakt K2 mit der ersten Metallisierungsebene verbunden, so daß für die erste und die zweite Metallisierungsebene, d. h. über die Anschlüsse A4 und A2, die Hall-Spannung abgegriffen werden kann. Aus Fig. 3 ist zu sehen, daß im Bereich des Kontakts K4 die zweite Metallisierungsebene von der flächigen zweiten Metallisierungsebene über dem Bereich 100 isoliert ist, und daß ferner am Kontakt K4 im Kontaktbereich 32 ebenso wie im Kontaktbereich 30 die erste und die zweite Metallisierungsebene voneinander elektrisch isoliert sind, um hier keine Kurzschlüsse zu verursachen. Darüber hinaus ist zu sehen, daß der Kontakt K2 nicht mit der zweiten Metallisierungsebene verbunden ist, d. h. daß die zweite Metallisierungsebene nicht in den Bereich des Kontakts K2 reicht, um auch hier keinen Kurzschluß zu verursachen.

Das in Fig. 3 gezeigte Ausführungsbeispiel hat den Vorteil, daß nur noch zwei Anschlußbereiche vorhanden sind, und daß die Betriebsstromzuführung nicht nur über die Anschlüsse A1 und A3 erfolgen kann, sondern auch genauso über die Anschlüsse A2 und A4, was dann vorteilhaft ist, wenn ein Spinning-Current-Betrieb erwünscht ist.

Fig. 4 zeigt ein weiteres Ausführungsbeispiel der vorliegenden Erfindung, bei dem die Leiterstruktur zur Rückführung des Stroms nicht ober- bzw. unterhalb des Bereichs 100 angeordnet ist, sondern so ausgestaltet ist, daß sie den Bereich im wesentlichen umgibt. Dies wird derart erreicht, daß die Leiterstruktur in der Nähe des Kontakts K3 in zwei Leiterbereiche 10a und 10b aufgeteilt wird, derart, daß in den beiden Leiterbereichen 10a und 10b etwa der halbe Betriebsstrom I zurückfließt. Damit ergeben sich zwei Teilanschlüsse A3a und A3b für die Leiterstruktur. Diese beiden Anschlüsse, die in Fig. 4 getrennt gezeigt sind, können durch die äußere Beschaltung ohne weiteres wieder kurzgeschlossen werden, d. h. miteinander verbunden werden. Das in Fig. 4 gezeigte Ausführungsbeispiel ist zwar von seiner reduzierenden Wirkung auf die Magnetfelder außerhalb des Hall-Elements nicht ganz so effizient wie das erste Ausführungsbeispiel mit oberhalb bzw. unterhalb angeordneter Metallisierungsfläche, das in Fig. 4 gezeigte Ausführungsbeispiel hat jedoch den Vorteil, daß keine zwei unterschiedlichen Metallisierungsflächen benötigt werden. Diese Option kann somit auch eingesetzt werden, wenn nur eine Ebene genutzt werden kann. Um die Auswirkungen der Betriebsstromrückführung durch die Leiterstruktur 10a, 10b auf die an den Anschlüssen A2 und A4 abgreifbare Hall-Spannung möglichst gering zu halten, sollten die Leiter 10a und 10b möglichst gleich lang sein, damit sich der Betriebsstrom in gleichen Teilen aufteilt, da dann der ohmsche Widerstand der Leiter 10a und 10b gleich ist. Darüber hinaus sollten die beiden Elemente 10a und 10b möglichst symmetrisch auf beiden Seiten des Bereichs 10 zurückgeführt werden, wobei jedoch der genaue Weg der Rückführung nicht entscheidend ist. Die Auswirkungen der Betriebsstromrückführung auf die Hall-Spannung an den Anschlüssen A2 und A4 ist am besten, wenn sich der Strom genau hälftig in die Leiter 10a und 10b aufteilt, und wenn die Leiter möglichst symmetrisch bezüglich der Symmetrieachse des Bereichs sind, entlang der der Betriebsstrom I fließt. Abweichungen der Symmetrie führen jedoch nicht schlagartig zu einer nicht mehr vorhandenen Kompensation, sondern lediglich zu einem langsam anwachsenden Offset, der je nach Anwendung immer noch tolerierbar sein dürfte, jedoch bereits wesentlich reduziert ist im Vergleich zu dem in Fig. 5 gezeigten Fall, bei dem die Rückführung den Bereich 100 nicht umgibt.

**Patentansprüche**

1.  Hall-Element mit folgenden Merkmalen:

    einem Bereich (100), der eine Hall-Konstante ungleich Null hat;

    einem ersten Kontakt (K1) zum Zuführen eines Betriebsstroms (I) zu dem Bereich (100);

    einem dritten Kontakt (K3) zum Abführen des Betriebsstroms (I) von dem Bereich (100), wobei der erste und der dritte Kontakt (K1, K3) eine Betriebsstromrichtung in dem Bereich (100) definieren; und

    einem zweiten und einem vierten Kontakt (K2, K4) zum Abgreifen einer Hall-Spannung;

    **gekennzeichnet durch**
    eine Leiterstruktur (10; 10'; 10a, 10b), die mit dem ersten Kontakt (K1) oder dem dritten Kontakt (K3) verbunden ist und den Bereich (100) seitlich im wesentlichen umgibt, wobei die Leiterstruktur (10a, 10b) zwei Teilleiter (10a, 10b) aufweist, die beide mit dem ersten Kontakt (K1) verbunden sind, oder die beide mit dem dritten Kontakt (K3) verbunden sind, und die sich auf jeweils entgegengesetzten Seiten des Bereichs (100) um den Bereich (100) herum in Richtung des Kontakts, mit dem sie verbunden sind, erstrecken, so daß ein Betriebsstrom über den Kontakt, mit dem die zwei Teilleiter (10a, 10b) verbunden sind, in zwei Betriebsstromanteile über die zwei Teilleiter aufteilbar ist.

2. Hall-Element gemäß Anspruch 1, bei dem die zwei Teilleiter (10a, 10b) die gleiche Länge haben.

3. Hall-Element gemäß Anspruch 1 oder 2, bei dem der Bereich bezüglich einer Symmetrieachse symmetrisch ist, wobei sich der erste und der dritte Kontakt (K1, K3) auf dieser Symmetrieachse befinden, und wobei die Teilleiter (10a, 10b) bezüglich der Symmetrieachse zueinander symmetrisch sind.

4. Hall-Element gemäß einem der Ansprüche 1 bis 3, bei dem die Teilleiter der äußeren Umrandung des Bereichs (100) im wesentlichen folgen.

5. Hall-Element gemäß einem der vorhergehenden Ansprüche, bei dem der Bereich (100) rechteckförmig, quadratisch oder kreuzförmig ist.

6. Hall-Element mit folgenden Merkmalen:

   einem Bereich (100), der eine Hall-Konstante ungleich Null hat;
   einem ersten Kontakt (K1), einem zweiten Kontakt (K2), einem dritten Kontakt (K3) und einem vierten Kontakt (K4), die so ausgestaltet sind, daß
   entweder über den ersten und den dritten Kontakt (K1, K3) ein Betriebsstrom (I) zum Bereich (100) zugeführt und vom Bereich (100) wieder abgeführt und über den zweiten und den vierten Kontakt (K2, K4) eine Hall-Spannung abgegriffen werden kann,
   oder über den zweiten und den vierten Kontakt (K2, K4) ein Betriebsstrom (I) zum Bereich (100) zugeführt und vom Bereich (100) wieder abgeführt und über den ersten und den dritten Kontakt (K1, K3) eine Hall-Spannung abgegriffen werden kann;

   wobei leitfähige Flächen in einer ersten und in einer zweiten Ebene (ME1, ME2) vorhanden sind, die beide oberhalb des Bereichs (100), unterhalb des Bereichs (100) oder so bezüglich des Bereichs (100) angeordnet sind, daß eine der Ebenen oberhalb des Bereichs und die andere Ebene unterhalb des Bereichs (100) angeordnet ist,
   wobei eine erste leitfähige Fläche in der ersten Ebene (ME1) liegt und über den ersten Kontakt (K1) elektrisch leitend mit dem Bereich (100) verbunden ist;
   wobei eine zweite leitfähige Fläche in der ersten Ebene (ME1) liegt und über den zweiten Kontakt (K2) elektrisch leitend mit dem Bereich (100) verbunden ist;
wobei eine dritte leitfähige Fläche in der zweiten Ebene (ME2) liegt und über den dritten Kontakt (K3) elektrisch leitend mit dem Bereich (100) verbunden ist; und
wobei eine vierte leitfähige Fläche in der zweiten Ebene (ME2) liegt und über den vierten Kontakt (K4) elektrisch leitend mit dem Bereich (100) verbunden ist,
wobei abgesehen von der Verbindung über den Bereich (100) die erste, die zweite, die dritte und die vierte leitfähige Fläche jeweils voneinander elektrisch isoliert sind, und
wobei die leitfähigen Flächen so ausgestaltet sind, daß ein Betriebsstrom (I), der über den ersten Kontakt (K1) durch den Bereich (100) zum dritten Kontakt (K3) fließt, über die dritte leitfähige Fläche wieder in die Nähe des ersten Kontakts (K1) zurückfließen kann, bzw. daß ein Betriebsstrom (I), der über den vierten Kontakt (K4) durch den Bereich (100) zum zweiten Kontakt (K2) fließt, über die zweite leitfähige Fläche wieder in die Nähe des vierten Kontakts (K4) zurückfließen kann.

7. Hall-Element gemäß Anspruch 6, bei dem zwischen der ersten leitfähigen Fläche und dem Bereich (100) ein Dielektrikum angeordnet ist.

8. Hall-Element gemäß Anspruch 6 oder 7, bei dem zwischen der ersten leitfähigen Fläche und der zweiten leitfähigen Fläche ein Dielektrikum vorhanden ist.

9. Hall-Element gemäß einem der Ansprüche 6 bis 8, bei dem die erste und die zweite leitfähige Fläche aus Metall oder einem Halbleitermaterial besteht.

10. Hall-Element gemäß einem der Ansprüche 6 bis 9, bei dem die geometrische Form und Ausdehnung der ersten und der zweiten leitfähigen Fläche der geometrischen Form bzw. Ausdehnung des Bereichs (100) entspricht.

11. Hall-Element gemäß einem der Ansprüche 6 bis 10, bei dem der Bereich (100) eine Symmetrieachse aufweist, auf der der erste und der dritte Kontakt (K1, K3) angeordnet sind, und bei dem die leitfähige Fläche gemäß der Symmetrieachse ausgerichtet und symmetrisch ist.

12. Hall-Element gemäß einem der Ansprüche 6 bis 11, bei dem der erste Kontakt (K1) mit einem ersten Anschluß (A1) verbunden ist,
bei dem der zweite Kontakt (K2) mit einem zweiten Anschluß (A2) verbunden ist,
bei dem der dritte Kontakt (K3) mit einem dritten Anschluß (A3) verbunden ist,
bei dem der vierte Kontakt (K4) mit einem vierten Anschluß (A4) verbunden ist,
bei dem der erste und der dritte Anschluß (A1, A3) übereinander angeordnet sind, und
der zweite und der vierte Anschluß (A2, A4) übereinander angeordnet sind.

## Claims

1.  A Hall element comprising:

    a region (100) having a non-zero Hall constant;

    a first contact (K1) for supplying an operating current (I) to said region (100);

    a third contact (K3) for conducting the operating current (I) away from said region (100), said first and third contacts (K1, K3) defining a direction of the operating current within said region (100);

    a second and a fourth contact (K2, K4) for tapping a Hall voltage;

    **characterized by**
    a conductor pattern (10; 10'; 10a, 10b) connected to the first contact (K1) or to the third contact (K3) and substantially surrounding said region (100) laterally, said conductor pattern (10a, 10b) comprising two partial conductors (10a, 10b) that are both connected to the first contact (K1) or that are both connected to the third contact (K3) and extend, on respective opposite sides of said region (100), around said region (100) in the direction of the contact to which they are connected, such that an operating current across the contact to which said two partial conductors (10a, 10b) are connected, can be divided into two operating current shares across the two partial conductors.

2.  A Hall element according to claim 1, wherein the two partial conductors (10a, 10b) are of equal length.

3.  A Hall element according to claim 1 or 2, wherein said region is symmetric with respect to an axis of symmetry, said first and third contacts (K1, K3) being located on said axis of symmetry and said partial conductors (10a, 10b) being symmetric to each other with respect to said axis of symmetry.

4.  A Hall element according to any of claims 1 to 3, wherein the partial conductors substantially follow the outer contour of said region (100).

5.  A Hall element according to any of the preceding claims, wherein said region (100) is of rectangular, square or cruciform shape.

6.  A Hall element comprising:

    a region (100) having a non-zero Hall constant;

    a first contact (K1), a second contact (K2), a third contact (K3) and a fourth contact (K4) formed such an operating current (I) can be supplied to said region (100) and conducted away from said region (100) either via the first or the third contact (K1, K3) and a Hall voltage can be tapped via the second and the fourth contact (K2, K4), or such that an operating current (I) can be supplied to said region (100) and conducted away from said region (100) either via the second or the fourth contact (K2, K4) and a Hall voltage can be tapped via the first and the third contact (K1, K3);

    wherein conductive areas are provided in a first and in a second plane (ME1, ME2), which are both arranged above said region (100), below said region (100) or are arranged with respect to said region (100) such that one of the planes is arranged above said region and the other plane is arranged below said region (100);
    wherein a first conductive area is in the first plane (ME1) and is connected to said region (100) in electrically conductive manner via the first contact (K1);
    wherein a second conductive area is in the first plane (ME1) and is connected to said region (100) in electrically conductive manner via the second contact (K2);
    wherein a third conductive area is in the second plane (ME2) and is connected to said region (100) in electrically conductive manner via the third contact (K3);
    wherein a fourth conductive area is in the second plane (ME2) and is connected to said region (100) in electrically conductive manner via the fourth contact (K4);
    wherein, apart from the connection via said region (100), the first, second, third and fourth conductive areas are electrically isolated from one another; and wherein the conductive areas are formed such that an operating current (I) flowing to the third contact (K3) through said region (100) via the first contact (K1) can flow back again to the proximity of the first contact (K1) via the third conductive area or such that an operating current (I) flowing to the second contact (K2) through said region (100) via the fourth contact (K4) can flow back again to the proximity of the fourth contact (K4) via the second conductive area.

**7.** A Hall element according to claim 6, wherein a dielectric is arranged between said first conductive area and said region (100).

**8.** A Hall element according to claim 6 or 7, wherein a dielectric is provided between said first conductive area and said second conductive area.

**9.** A Hall element according to any of claims 6 to 8, wherein said first and second conductive areas consist of metal or a semiconductor material.

**10.** A Hall element according to any of claims 6 to 9, wherein the geometric shape and expanse of said first and second conductive areas corresponds to the geometric shape and expanse of said region (100), respectively.

**11.** A Hall element according to any of claims 6 to 10, wherein said region (100) has an axis of symmetry on which said first and third contacts (K1, K3) are arranged, and wherein the conductive area is symmetric and oriented in accordance with the axis of symmetry.

**12.** A Hall element according to any of claims 6 to 11, wherein said first contact (K1) is connected to a first terminal (A1), wherein said second contact (K2) is connected to a second terminal (A2), wherein said third contact (K3) is connected to a third terminal (A3), wherein said fourth contact (K4) is connected to a fourth terminal (A4), wherein said first and third terminals (A1, A3) are arranged on top of each other, and wherein said second and fourth terminals (A2, A4) are arranged on top of each other.

**Revendications**

**1.** Élément à effet Hall aux caractéristiques suivantes :

une zone (100) ayant une constante de Hall différente de zéro ;
un premier contact (K1) destiné à alimenter une énergie primaire (I) vers la zone (100) ;
un troisième contact (K3) destiné à évacuer l'énergie primaire (I) de la zone (100), les premier et troisième contacts (K1, K3) définissant une direction d'énergie primaire dans la zone (100) ; et
un deuxième et un quatrième contact (K2, K4) destinés à mesurer une tension de Hall ;

**caractérisé par**
une structure de conducteurs (10; 10'; 10a, 10b) qui est reliée au premier contact (K1) ou au troisième contact (K3) et qui entoure substantiellement la zone (100) latéralement, la structure de conducteurs (10a, 10b) présentant deux connecteurs partiels (10a, 10b) reliés tous deux au premier contact (K1), ou reliés tous deux au troisième contact (K3), et qui s'étendent, chacun, sur des côtés opposés de la zone (100), tout autour de la zone (100), en direction du contact auquel ils sont reliés, de sorte qu'une énergie primaire puisse être divisée, par l'intermédiaire du contact auquel sont reliés les deux conducteurs partiels (10a, 10b), en deux parties d'énergie primaire sur les deux conducteurs partiels.

**2.** Élément à effet Hall selon la revendication 1, dans lequel les deux conducteurs partiels (10a, 10b) ont la même longueur.

**3.** Élément à effet Hall selon la revendication 1 ou 2, dans lequel la zone est symétrique par rapport à un axe de symétrie, les premier et troisième contacts (K1, K3) se situant sur cet axe de symétrie et les conducteurs partiels (10a, 10b) étant symétriques entre eux par rapport à l'axe de symétrie.

**4.** Élément à effet Hall selon l'une des revendications 1 à 3, dans lequel les conducteurs partiels suivent substantiellement le bord extérieur de la zone (100).

**5.** Élément à effet Hall selon l'une des revendications précédentes, dans lequel la zone (100) est rectangulaire, carrée ou en forme de croix.

**6.** Élément à effet Hall aux caractéristiques suivantes :

une zone (100) ayant une constante de Hall différente de zéro ;
un premier contact (K1), un deuxième contact (K2), un troisième contact (K3) et un quatrième contact (K4) réalisés de sorte que
soit par le premier et le troisième contact (K1, K3) une énergie primaire (I) est alimentée vers la zone (100) et à nouveau évacuée de la zone (100) et que par le second et le quatrième contact (K2, K4) peut être mesurée une tension de Hall,
soit par le deuxième et le quatrième contact (K2, K4) une énergie primaire (I) est alimentée vers la zone (100) et à nouveau évacuée de la zone (100) et que par le premier et le troisième contact (K1, K3) peut être mesurée une tension de Hall,
des surfaces conductrices étant présentes dans un premier et dans un deuxième plan (ME1, ME2) disposés, tous deux, au-dessus de la zone (100), au-dessous de la zone (100) ou de telle sorte par rapport à la zone (100) que l'un des plans est disposé au-dessus de la zone et l'autre plan est disposé au-dessous de la zone (100),

une première surface conductrice se situant dans le premier plan (ME1) et étant reliée de manière électroconductrice, par le premier contact (K1), à la zone (100) ;

une deuxième surface conductrice se situant dans le premier plan (ME1) et étant reliée de manière électroconductrice, par le deuxième contact (K2), à la zone (100) ;

une troisième surface conductrice se situant dans le deuxième plan (ME2) et étant reliée de manière électroconductrice, par le troisième contact (K3), à la zone (100) ; et

une quatrième surface conductrice se situant dans le deuxième plan (ME2) et étant reliée de manière électroconductrice, par le quatrième contact (K4), à la zone (100),

en dehors du raccordement sur la zone (100), la première, la deuxième, la troisième et la quatrième surface conductrice étant, chacune, isolée électriquement l'une de l'autre, et

les surfaces conductrices étant réalisées de sorte qu'une énergie primaire (1) qui circule par le premier contact (K1), à travers la zone (100), vers le troisième contact (K3) peut, par la troisième surface conductrice, retourner vers le voisinage du premier contact (K1), ou qu'une énergie primaire (I) qui circule par le quatre contact (K4), à travers la zone (100), vers le deuxième contact (K2) peut, par la deuxième surface conductrice, retourner vers le voisinage du quatrième contact (K4).

7. Élément à effet Hall selon la revendication 6, dans lequel entre la première surface conductrice et la zone (100) est disposé un diélectrique.

8. Élément à effet Hall selon la revendication 6 ou 7, dans lequel entre la première surface conductrice et la deuxième surface conductrice est présent un diélectrique.

9. Élément à effet Hall selon l'une des revendications 6 à 8, dans lequel les première et deuxième surfaces conductrices sont réalisées en métal ou un matériau semi-conducteur.

10. Élément à effet Hall selon l'une des revendications 6 à 9, dans lequel la forme géométrique et l'extension des première et deuxième surfaces conductrices correspondent à la forme géométrique ou à l'extension de la zone (100).

11. Élément à effet Hall selon l'une des revendications 6 à 10, dans lequel la zone (100) présente un axe de symétrie sur lequel sont disposés les premier et troisième contacts (K1, K3) dans lequel la surface conductrice est orientée selon l'axe de symétrie et de manière symétrique.

12. Élément à effet Hall selon l'une des revendications 6 à 11,

dans lequel le premier contact (K1) est relié à une première connexion (A1),

dans lequel le deuxième contact (K2) est relié à une deuxième connexion (A2),

dans lequel le troisième contact (K3) est relié à une troisième connexion (A3),

dans lequel le quatrième contact (K4) est relié à une quatrième connexion (A4),

dans lequel les première et troisième connexions (A1, A3) sont disposées l'une au-dessus de l'autre, et

les deuxième et quatrième connexions (A2, A4) sont disposées l'une au-dessus de l'autre.

Fig. 1A

Fig. 1B

**Fig. 2**

**Fig. 3**

EP 1 230 557 B1

A4 A3a A1 A3b A2

I K1

K4 K2

K3 100

10a 10b

**Fig. 4**

A4 A1 A2 A3

110 100 130

I 140

K1

K4 K2

130c

120

K3

130a

130b

**Fig. 5**

13